# EUROPEAN PATENT APPLICATION

(11) **EP 2 811 532 A1**
(43) Date of publication of application: **10.12.2014**
(21) Application number: 12867704.4
(22) Date of filing: 31.01.2012
(51) Int. Cl.: H01L 31/042

(54) **SOLAR CELL MODULE, AND METHOD FOR MANUFACTURING SOLAR CELL MODULE**

(71) Applicant: Sanyo Electric Co., Ltd., Moriguchi-shi, Osaka 570-8677 (JP)
(72) Inventor: YOSHIMINE, Yukihiro, Moriguchi-shi Osaka 570-8677 (JP)
(74) Representative: Klunker . Schmitt-Nilson . Hirsch
(86) International application number: PCT/JP2012/052094
(87) International publication number: WO 2013/114555

(57) **Abstract**

A solar cell module (10) is provided with: solar cells (11), each of which has bus bar sections (25, 26) on main surfaces thereof; adhesive layers (27), which are provided on the bus bar sections (25, 26), respectively; and a wiring material (17), which is connected to the bus bar sections (25, 26) by means of the adhesive layers (27), and which is bent, at regions in contact with the adhesive layers (27), to the upper side of the bus bar sections (25, 26), from bent portions (17a-17d) toward end portions of the adhesive layers (27).

## Description

### TECHNICAL FIELD

The present invention relates to a solar cell module and a method for manufacturing the solar cell module.

### BACKGROUND ART

For solar cell modules, various proposals have been made for connecting wiring materials to connection electrodes of solar cells. Patent Document 1 discloses a solar cell module in which connection electrodes of solar cells and wiring materials are connected to each other by means of an adhesive of a thermosetting resin or the like.

### CITATION LIST

### PATENT DOCUMENTS

Patent Document 1: Japanese Patent Laid-Open Publication No. 2009-206493

### SUMMARY OF INVENTION

### TECHNICAL PROBLEM

In the field of solar cell modules, there are demands to prevent wiring materials from coming off connection electrodes.

### SOLUTION TO PROBLEM

A solar cell module according to the present invention includes: solar cells each including a connection electrode on a main surface thereof; an adhesive layer provided on each connection electrode; and a wiring material that is connected to each connection electrode by means of the adhesive layer and is bent, at regions in contact with the adhesive layer, to the connection electrode side from bent portions toward end portions of the adhesive layer.

A method for manufacturing a solar cell module according to the present invention includes: providing an adhesive layer on a connection electrode provided on a main surface of each of solar cells; and connecting, when a wiring material is connected to the connection electrode by means of the adhesive layer, the wiring material to the adhesive layer in a state where the wiring material is bent, at regions in contact with the adhesive layer, to the connection electrode side from bent portions toward end portions of the adhesive layer.

### ADVANTAGEOUS EFFECT OF INVENTION

According to the present invention, wiring materials may be prevented from coming off connection electrodes.

### BRIEF DESCRIPTION OF DRAWINGS

[FIG. 1] FIG. 1 is a plan view of a solar cell module according to an embodiment of the present invention, as observed from a light-receiving surface side.
[FIG. 2] FIG. 2 is a sectional view taken along an A-A line in FIG. 1.
[FIG. 3] FIG. 3 is a view illustrating a sectional observation state of an end portion of a wiring material of the solar cell module according to the embodiment of the present invention.
[FIG. 4] FIG. 4 is a view illustrating a state where the wiring material of the solar cell module according to the embodiment of the present invention is cut.
[FIG. 5] FIG. 5 is a view illustrating a state where the wiring material of the solar cell module according to the embodiment of the present invention is pressed.
[FIG. 6] FIG. 6 is a view illustrating a state where the wiring materials of the solar cell module according to the embodiment of the present invention are connected to a solar cell.
[FIG. 7] FIG. 7 is a sectional view of a solar cell module according to a modified example of the embodiment of the present invention.
[FIG. 8] FIG. 8 is a view illustrating a state where a wiring material of the solar cell module according to the modified example of the embodiment of the present invention is cut.
[FIG. 9] FIG. 9 is a view illustrating a state where the wiring material of the solar cell module according to the modified example of the embodiment of the present invention is pressed.
[FIG. 10] FIG. 10 is a view illustrating a state where the wiring material of the solar cell module according to the modified example of the embodiment of the present invention is pressed.

### DESCRIPTION OF EMBODIMENT

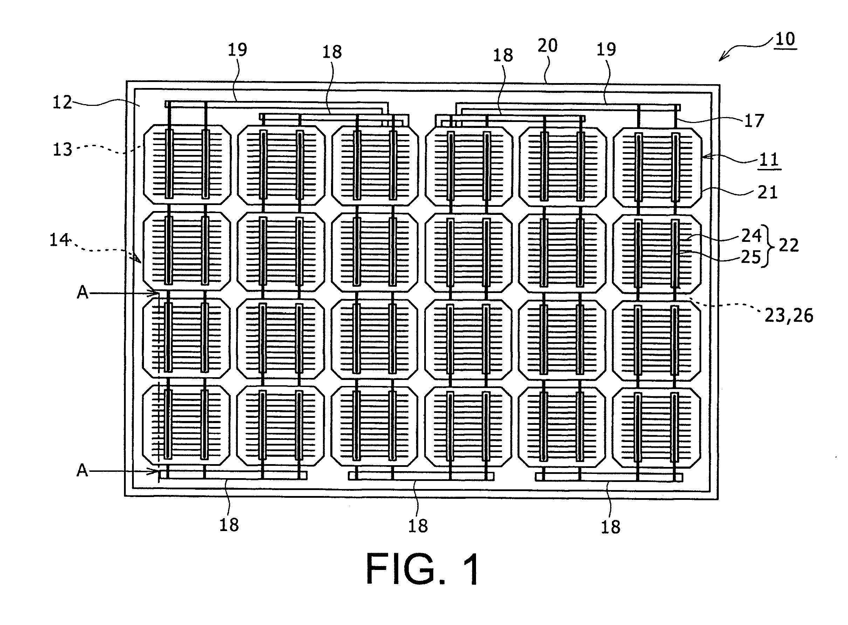

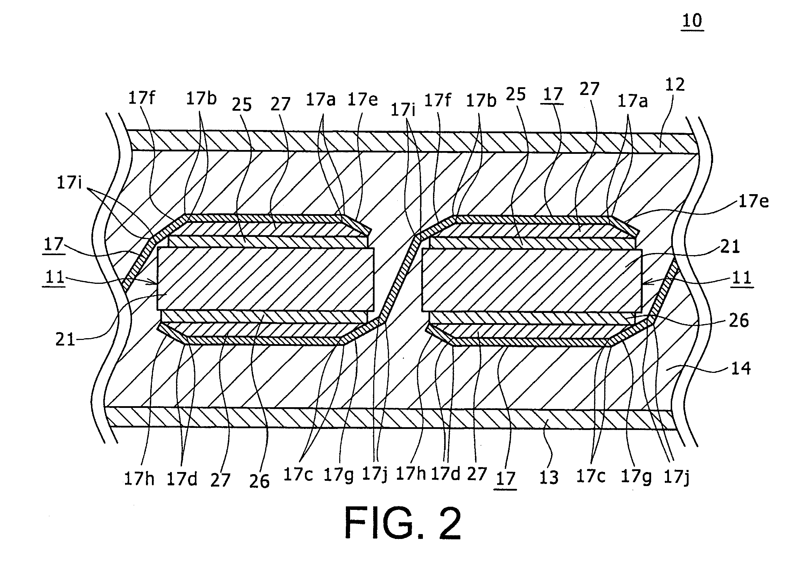

As illustrated in FIG. 1 and FIG. 2, a solar cell module 10 includes: a plurality of solar cells 11; wiring materials 17 that connect the solar cells 11 to each other; crossover wiring materials 18 that connect the wiring materials 17 to each other; output wiring materials 19 for taking an output to the outside; a first protecting member 12 placed on a light-receiving surface side of the solar cells 11; a second protecting member 13 placed on a rear surface side of the solar cells 11; a filling material 14 that fills a space between the solar cells 11 and the first protecting member 12 and a space between the solar cells 11 and the second protecting member 13; and a frame 20 attached to end portions of the first protecting member 12 and the second protecting member 13.

The "light-receiving surface" is one of the main surfaces of each solar cell 11, and refers to a surface through which light from the outside mainly enters. For example, 50% to 100% of the light that enters each solar cell 11 enters from the light-receiving surface side. The "rear surface" is one of the main surfaces of each solar cell 11, and refers to a surface opposite the light-receiving surface.

A transparent plate or film (for example, a translucent member such as a glass plate, a resin plate, or a resin film) can be used for the first protecting member 12. Similar to the case of the first protecting member 12, a glass plate, a resin plate, a resin film, or the like can be used for the second protecting member 13. Note that, in the case where light reception from the rear surface side is not assumed, an opaque plate or film may be used for the second protecting member 13, and, for example, a laminate film such as a resin film having aluminum foil therein may be used therefor.

Each solar cell 11 includes: a photoelectric conversion section 21 that receives light such as sunlight to thereby generate carriers (electrons and holes); a light-receiving surface electrode 22 provided on a light-receiving surface of the photoelectric conversion section 21; and a rear surface electrode 23 provided on a rear surface of the photoelectric conversion section 21. In the solar cell 11, the carriers generated by the photoelectric conversion section 21 are collected by the light-receiving surface electrode 22 and the rear surface electrode 23. The light-receiving surface electrode 22 and the rear surface electrode 23 are made of metal. Note that, in order to reduce a light shielding loss, preferably, the light-receiving surface electrode 22 is smaller in area than the rear surface electrode 23.

The photoelectric conversion section 21 includes, for example, a substrate made of a semiconductor material such as crystalline silicon, gallium arsenide (GaAs), or indium phosphide (InP). No particular limitation is imposed on the structure of the photoelectric conversion section 21, and in the present embodiment the structure is described as having a heterojunction between an n-type single-crystal silicon substrate and amorphous silicon. In the photoelectric conversion section 21, for example, an i-type amorphous silicon layer, a p-type amorphous silicon layer doped with boron (B) and the like, and a transparent conductive layer made of a translucent conductive oxide such as indium oxide are laminated in the stated order on a light-receiving surface of the n-type single-crystal silicon substrate. Further, an i-type amorphous silicon layer, an n-type amorphous silicon layer doped with phosphorus (P) and the like, and a transparent conductive layer are laminated in the stated order on a rear surface of the substrate.

The light-receiving surface electrode 22 includes a plurality of (for example, 50) finger sections 24 and a plurality of (for example, 2) bus bar sections 25.

The finger sections 24 and the bus bar sections 25 are placed so as to intersect with each other, and are electrically connected to each other. The finger sections 24 and the bus bar sections 25 are formed by, for example, screen-printing a desired pattern on the transparent conductive layer using a conductive paste in which a conductive filler of silver (Ag) and the like is dispersed in a binder resin.

The finger sections 24 are electrodes that collect carriers evenly across the entire photoelectric conversion section 21. The finger sections 24 are placed so as to be parallel to each other with a predetermined interval (for example, 1.5 mm to 3 mm) over substantially the entire light-receiving surface. The width of each finger section 24 is preferably about 50 µm to 150 µm, and the thickness thereof is preferably about 20 µm to 80 µm.

The bus bar sections 25 are connection electrodes to which the wiring materials 17 are respectively electrically connected with the intermediation of an adhesive layer 27. For example, metal such as copper can be used for the wiring materials 17. For example, a thermosetting adhesive containing an adhesive resin material such as epoxy resin, acrylic resin, or urethane resin can be used for the adhesive layer 27. Further, for example, an anisotropic conductive adhesive in which conductive particles are uniformly dispersed in an adhesive having high insulation properties can also be used for the adhesive layer 27.

The bus bar sections 25 are placed so as to be parallel to each other with a predetermined interval. The bus bar sections 25 mainly serve for power collection of carriers from the finger sections 24 and transmission thereof to the wiring materials 17. The width of each bus bar section 25 is preferably about 1.5 mm to 3 mm, and the thickness thereof is preferably about 20 µm to 160 µm.

Similar to the light-receiving surface electrode 22, the rear surface electrode 23 includes a plurality of finger sections (not illustrated) and a plurality of bus bar sections 26 (connection electrodes). The number of the finger sections of the rear surface electrode 23 may be set to be larger than the number of the finger sections 24, and the interval thereof may be set to be smaller than the interval of the finger sections 24 (for example, number: 250 and interval: 0.5 mm). Note that, in the case where light reception from the rear surface side is not assumed, the rear surface electrode 23 may be obtained by forming a metal film such as a silver (Ag) thin film over the entire rear surface of the photoelectric conversion section 21.

Next, a connection relation between the wiring materials 17 and the solar cells 11 and the like is described in detail.

As illustrated in FIG. 2, two adjacent solar cells 11 are electrically connected to each other by the wiring materials 17. The wiring materials 17 are placed along the arrangement of the solar cells 11. The wiring materials 17 are respectively joined to: the bus bar sections 25 formed on the light-receiving surface of one solar cell 11; and the bus bar sections 26 formed on the rear surface of the other solar cell 11, by means of the adhesive layers 27. As a result, the bus bar sections 25 and the bus bar sections 26 are electrically connected to each other.

The wiring materials 17 are respectively connected to the bus bar sections 25, 26 by means of the adhesive layers 27, and are bent, at regions in contact with the adhesive layers 27, to the bus bar section 25, 26 sides from bent portions 17a to 17d toward end portions of the adhesive layers 27. The "bent portions" refer to folds that are formed in each wiring material 17 by press working or wiring material cutting to be described later.

Each wiring material 17 is provided so as to be laid between a boundary portion 17i on the light-receiving surface of the one solar cell 11 and a boundary portion 17j on the rear surface of the other solar cell 11. The "boundary portions" refer to folds that are formed by press working to be described later such that the wiring material 17 can be laid between the light-receiving surface of the one solar cell 11 and the rear surface of the other solar cell 11 located on the opposite side. The bent portions 17a to 17d are provided on the end portion sides of the wiring material 17 with respect to the boundary portions 17i, 17j. The bent portions 17a, 17d are provided in the vicinities of the end portions of the wiring material 17. The bent portions 17b, 17c are provided in the vicinities of the boundary portions 17i, 17j of the wiring material 17.

Each wiring material 17 includes inclined portions 17e to 17h that are portions that respectively extend from the bent portions 17a to 17d toward the end portions of the adhesive layers 27. The inclined portions 17e to 17h are respectively inclined from the bent portions 17a to 17d to the bus bar section 25, 26 sides. Here, each of the lengths of the inclined portions 17e to 17h is preferably about 10% to 20% (for example, 1 cm to 2 cm) of the length along the extending direction of the wiring material 17, of the plane of the photoelectric conversion section 21.

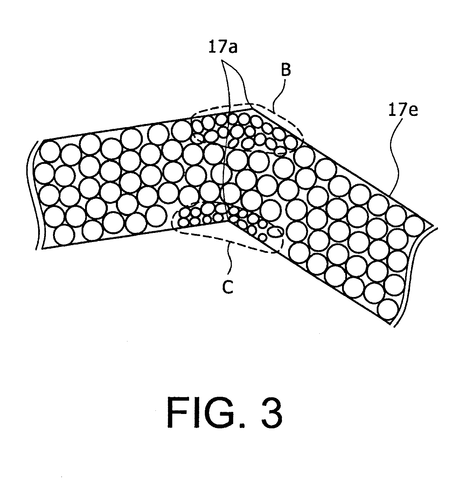

As illustrated in FIG. 3, if a section of the wiring material 17 (representatively, the bent portion 17a) is observed using, for example, a scanning electron microscope (SEM), the particle diameters of metal atoms are smaller in an outer region B and an inner region C than in the remaining regions. That is, the crystal density is higher in the outer region B and the inner region C than in the remaining regions. For example, the crystal density is higher by 30% to 50% in the outer region B and the inner region C than in the remaining regions. The bent portions 17b to 17d each have a sectional structure similar to that of the bent portion 17a.

Next, a method for manufacturing the solar cell module 10 is described.

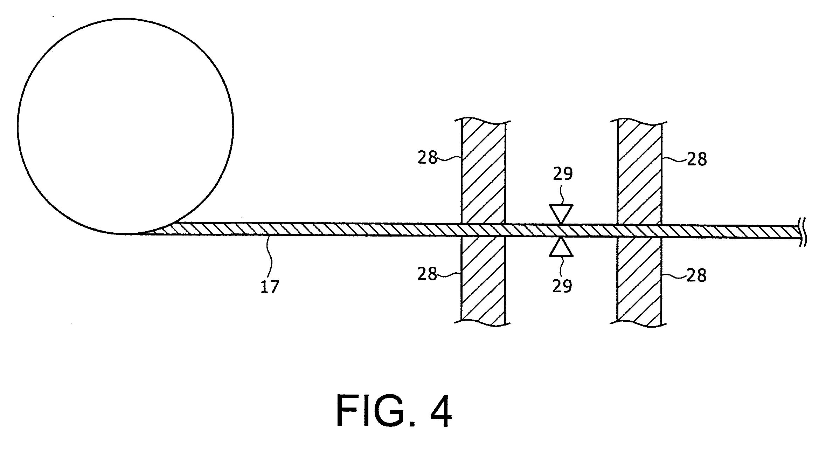

First, as illustrated in FIG. 4, the wiring material 17 is fixed from above and below by chuck devices 28, and the wiring material 17 is cut from above and below by a cutter 29.

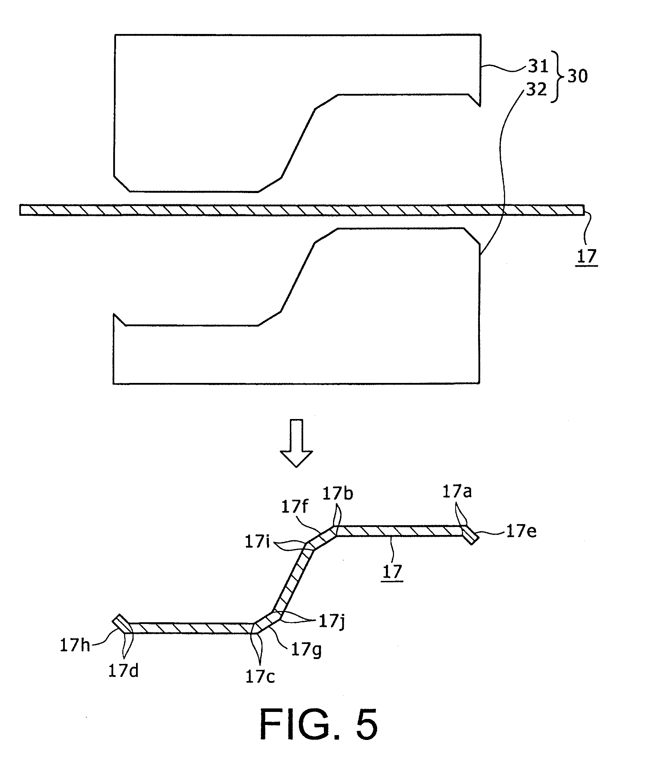

Subsequently, as illustrated in an upper part of FIG. 5, the cut wiring material 17 is fitted into a die 30 to be pressed. Consequently, as illustrated in a lower part of FIG. 5, the wiring material 17 that is bent so as to follow the shape of the die 30 is formed. The die 30 includes a pair of a first die section 31 and a second die section 32 having concave and convex portions that are necessary to bend the wiring material 17 at the bent portions 17a to 17d and thus form the inclined portions 17e to 17h.

Subsequently, the adhesive layers 27 are respectively formed on the bus bar sections 25 and the bus bar sections 26 of two adjacent solar cells 11, and the wiring materials 17 are placed thereon. At this time, the wiring materials 17 are placed in a state where the wiring materials 17 are bent, at the regions in contact with the adhesive layers 27, to the bus bar section 25, 26 sides from the bent portions 17a to 17d toward the end portions of the adhesive layers 27. Specifically, the wiring materials 17 are placed such that: the inclined portions 17e, 17f thereof are respectively located on top of the end portions of the adhesive layer 27 on the bus bar sections 25; and the inclined portions 17g, 17h thereof are respectively located on top of the end portions of the adhesive layer 27 on the bus bar sections 26.

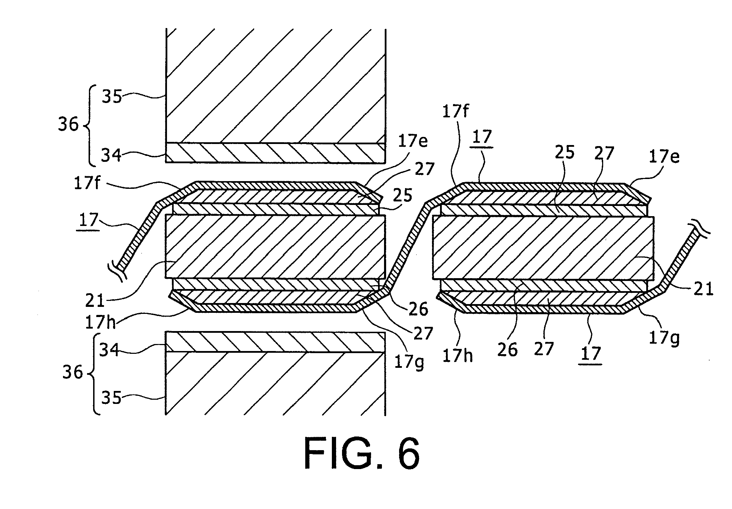

Subsequently, as illustrated in FIG. 6, heating is performed in a state where a heating device 36 is compression-bonded to the wiring materials 17 from above and below, whereby the adhesive layers 27 are thermally cured to connect the wiring materials 17 and the solar cell 11. The heating device 36 includes a flexible sheet material 34 made of a silicone resin and the like and a heater 35. The wiring materials 17 are placed in the state where the wiring materials 17 are bent, at the regions in contact with the adhesive layers 27 on the bus bar sections 25, 26, to the bus bar section 25, 26 sides toward the end portions of the adhesive layers 27. As a result, the wiring materials 17 are firmly joined to the bus bar sections 25, 26 also in the inclined portions 17e to 17h. Accordingly, even when the heating device 36 is separated from the wiring materials 17 after the end of the thermal compression bonding by the heating device 36, the wiring materials 17 can be prevented from coming off the bus bar sections 25, 26.

The present invention includes various embodiments that are not described herein.

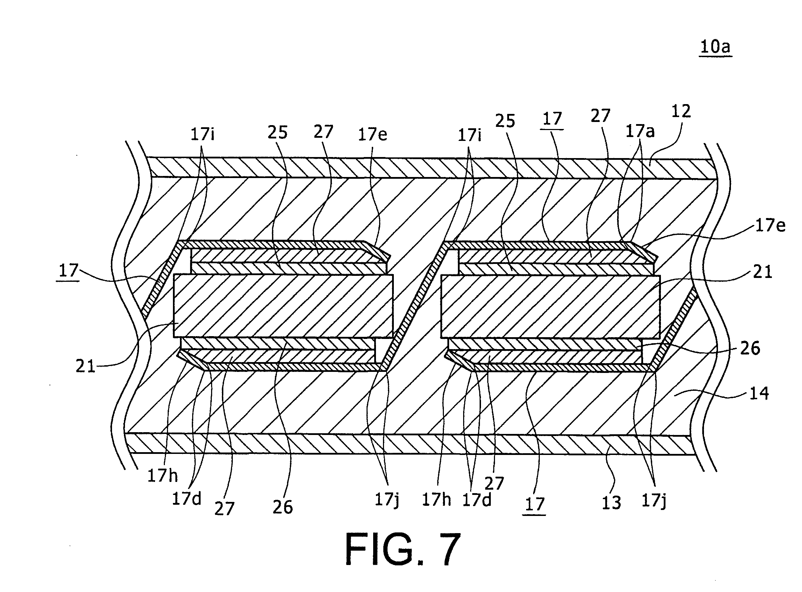

For example, the wiring materials 17 do not necessarily need to be bent at all the bent portions 17a to 17d, and may be bent at only part(s) thereof. Specifically, as illustrated in FIG. 7, in a solar cell module 10a, the wiring materials 17 are not bent at portions corresponding to the bent portions 17b, 17c. Meanwhile, similarly to the solar cell module 10, the wiring materials 17 are respectively connected to the bus bar sections 25, 26 by means of the adhesive layers 27, and are bent, at the regions in contact with the adhesive layers 27, to the bus bar section 25, 26 sides from the bent portions 17a, 17d toward the end portions of the adhesive layers 27. That is, in the solar cell module 10a, the inclined portions 17e, 17h of each wiring material 17 are inclined to the bus bar section 25, 26 sides.

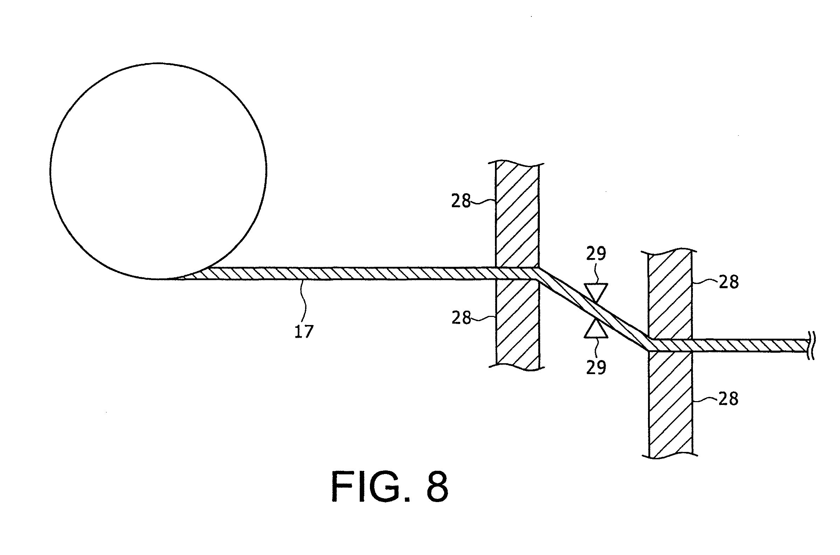

Further, the wiring materials 17 do not necessarily need to be bent by the die 30 at all the bent portions 17a to 17d. For example, in the step of cutting each wiring material 17, the wiring material 17 may be bent at the bent portions 17a, 17d. Specific description thereof is given. As illustrated in FIG. 8, the positions of the chuck devices 28 are shifted with respect to each other in the top-bottom direction, the wiring material 17 is fixed to the chuck devices 28, and the wiring material 17 is cut from above and below by the cutter 29. Consequently, in this stage, the wiring material 17 is bent at the bent portions 17a, 17d, whereby the inclined portions 17e, 17h are formed.

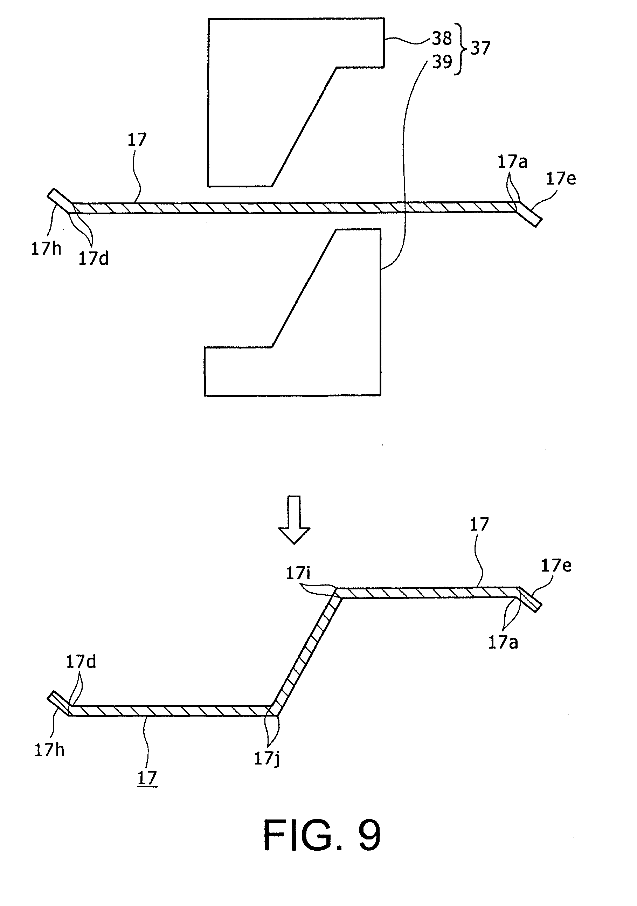

With the use of the wiring material 17 that is bent at the bent portions 17a, 17d in such a manner, as illustrated in an upper part of FIG. 9, the cut wiring material 17 is fitted into a die 37 to be pressed. The die 37 includes a pair of a first die section 38 and a second die section 39 having concave and convex portions for forming a bent shape that is necessary to lay the wiring material 17 between each bus bar section 25 and each bus bar section 26. Unlike the die 30, the die 37 does not have such concave and convex portions that bend the wiring material 17 at the bent portions 17b, 17d. The wiring material 17 is pressed using the die 37 thus configured. Consequently, as illustrated in a lower part of FIG. 9, the wiring material 17 that is bent so as to follow the concave and convex portions of the die 37 is formed.

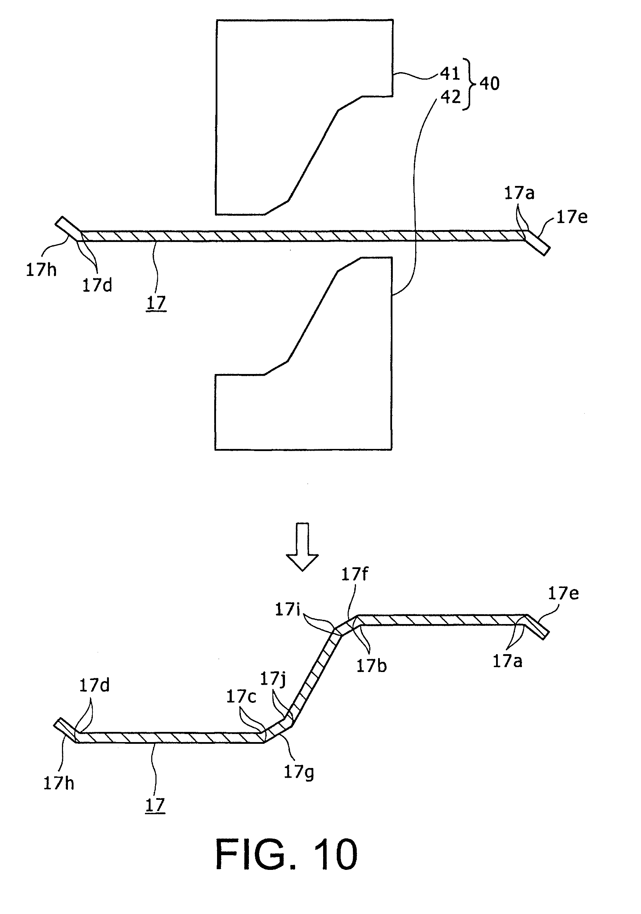

Further, even in the case of using the wiring material 17 bent at the bent portions 17a, 17d, as illustrated in an upper part of FIG. 10, the wiring material 17 may be pressed using a die 40 including a pair of a first die section 41 and a second die section 42 having concave and convex portions that are necessary to bend the wiring material 17 at the bent portions 17b, 17c and thus form the inclined portions 17f, 17g. Consequently, as illustrated in a lower part of FIG. 10, the wiring material 17 in which not only the inclined portions 17e, 17h but also the inclined portions 17f, 17g are inclined can be formed.

### REFERENCE SIGNS LIST

10, 10a solar cell module, 11 solar cell, 12 first protecting member, 13 second protecting member, 14 filling material, 17 wiring material, 17a, 17b, 17c, 17d bent portion, 17i, 17j boundary portion, 18 crossover wiring material, 19 output wiring material, 20 frame, 21 photoelectric conversion section, 22 light-receiving surface electrode, 23 rear surface electrode, 24 finger section, 25, 26 bus bar section, 27 adhesive layer, 28 chuck device, 29 cutter, 30, 37, 40 die, 31, 38, 41 first die section, 32, 39, 42 second die section, 34 sheet material, 35 heater

## Claims

1. A solar cell module comprising:
solar cells each including a connection electrode on a main surface thereof;
an adhesive layer provided on each connection electrode; and
a wiring material that is connected to each connection electrode by means of the adhesive layer and is bent, at regions in contact with the adhesive layer, to the connection electrode side from bent portions toward end portions of the adhesive layer.

2. The solar cell module according to claim 1, wherein the bent portions are respectively provided in vicinities of end portions of the wiring material.

3. The solar cell module according to claim 1 or claim 2, wherein
the wiring material is provided so as to be laid between a boundary portion on a light-receiving surface of one solar cell and a boundary portion on a rear surface of another solar cell, and
the bent portions are respectively provided on the end portion sides of the wiring material with respect to the boundary portions.

4. The solar cell module according to claim 3, wherein the bent portions are respectively provided in vicinities of the boundary portions.

5. A method for manufacturing a solar cell module comprising:
providing an adhesive layer on a connection electrode provided on a main surface of each of solar cells; and
connecting, when a wiring material is connected to the connection electrode by means of the adhesive layer, the wiring material to the adhesive layer in a state where the wiring material is bent, at regions in contact with the adhesive layer, to the connection electrode side from bent portions toward end portions of the adhesive layer.

6. The method for manufacturing a solar cell module according to claim 5, wherein the bent wiring material is formed by press working.

7. The method for manufacturing a solar cell module according to claim 5, wherein the bent wiring material is formed by cutting the wiring material.
